# EUROPÄISCHE PATENTSCHRIFT

(11) **EP 1 801 598 B1**
(45) Veröffentlichungstag und Bekanntmachung des Hinweises auf die Patenterteilung: **08.09.2010**
(21) Anmeldenummer: 06020080.5
(22) Anmeldetag: 26.09.2006
(51) Int. Cl.: G01R 1/04, G01R 15/00

(54) **Multimeter**
Multimeter
Multimètre

(30) Priorität: 23.12.2005 DE 102005062624
(43) Veröffentlichungstag der Anmeldung: 27.06.2007
(73) Patentinhaber: GMC-I Gossen-Metrawatt GmbH, D-90471 Nürnberg (DE)
(72) Erfinder: Koops, Dietmar, 90530 Wendelstein/Grossschwarzenlohe (DE); Fischer, Günter, 90530 Wendelstein (DE)
(74) Vertreter: Hafner, Dieter

(56) Entgegenhaltungen:
- EP-A- 0 474 086
- EP-A- 0 723 158
- US-A- 4 951 834
- US-A- 5 442 337
- US-A- 5 621 311

## Beschreibung

Die Erfindung betrifft ein Multimeter mit einem Gehäuse, das mindestens drei als Steckbuchsen ausgeführte Eingangsanschlüsse zum Anschließen von zwei Meßleitungen aufweist, mit den weiteren Merkmalen des Oberbegriffes 1.

US 4,951,834 lehrt eine gegossene Dichtung für ein Multimetergehäuse. An der äußeren Oberfläche einer der beiden das Multimeter bildenden Gehäuseschalen ist umfänglich eine Serie von Dichtungsverschlußelementen angeordnet. Dabei bilden die mit einem Spritzgußverfahren hergestellten, eine Serie von zinkenartig geformten Dichtungsverschlußelementen ein Siegel zwischen der oberen und unteren Gehäuseschale.

EP 0 723 158 A1 lehrt Vielfachmeßgerät, das eine Falscheingabe-Verhinderungseinrichtung in Form einer Verschlußplatte aufweist. Die Verschlußplatte ist in einem vorgegebenen Winkelbereich auf der Grundlage der Drehoperation des Drehschalters rotierbar und verschließt sequentiell Anschlußlöcher zum Verbinden des Vielfachmeßgerätes mit einem Meßkabel. Jedoch wird das Masse-Anschlußloch unabhängig von der Lage des Drehschalters bzw. der Verschlußplatte im offenen Zustand belassen.

EP 0 474 086 A2 beschreibt ein Multimeter mit einem Gehäuse bestehend aus mehreren Wandungen mit mindestens drei als Steckbuchse ausgeführten Eingangsanschlüssen zum Anschließen von zwei Meßleitungen, wobei der Meßbereichsschalter bei angeschlossenen Meßleitungen nicht auf den Meßbereich einer anderen Meßgröße umschaltbar ist, so daß eine Sperrkulisse dem Aufbau des zugehörigen Meßbereichsschalters angepaßt und als Drehkulisse ausgebildet ist und in der Sperrkulisse mindestens eine Aussparung vorgesehen ist, deren Positionierung mit der Schalterstellung des Meßbereichsschalters so korrespondiert, daß die Aussparung jeweils den Aufnahmekanal des als Steckbuchse ausgebildeten Eingangsanschlusses freigibt.

US 5,442,337 lehrt ein Multimeter mit mehreren Eingangsbuchsen, wobei wenigstens eine Eingangsbuchse über ein federndes Sperrelement bei definierten Positionen des Wahlschalters des Multimeters versperrt wird. Dabei ist die Sperrplatte federnd vorgespannt und beaufschlagt über eine Kulissenführung den Wahldrehschalter des Multimeters. Hierbei bleibt ebenfalls die Masseöffnung stets frei zugänglich für die Stecker.

Ein derartiges Multimeter ist aus EP 0 474 086 B1 bekannt. Das bekannte Multimeter zeichnet sich dadurch aus, daß es einen Meßbereichsschalter aufweist, der in eine der gewählten Meßgrößen zugeordnete Schaltstellung zu bringen ist, wobei mit dem Meßbereichsschalter eine mechanisch wirkende Sperrvorrichtung gekoppelt ist, die eine Sperrung bestimmter Eingangsanschlüsse in der Weise erlaubt, daß eine über die Meßleitungen ein Meßsignal aufnehmende Kontaktierung nur jeweils der Eingangsanschlüsse erfolgen kann, denen eine Meßgröße zugeordnet ist, die der mit dem Meßbereichsschalter eingestellten Meßgröße entspricht. Bei diesem Stand der Technik ist die Sperrvorrichtung eine plattenartige Sperrkulisse, die der Art und dem Aufbau des zugehörigen Meßbereichsschalters angepaßt ist und in der eine Aussparung vorgesehen ist, deren Positionierung mit der Schaltstellung des Meßbereichsschalters so korrespondiert, daß die Aussparung jeweils den Aufnahmekanal des als Steckbuchse ausgebildeten Eingangsanschlusses freigeben, der mit dem Meßbereichsschalter eingestellten Meßgröße zugeordnet ist.

Darüber hinaus ist aus dem japanischen Gebrauchsmuster SHO 62-39333 ein Prüfgerät mit den Merkmalen des Oberbegriffes des Anspruches 1 bekannt, bei dem die Sperrvorrichtung als Linearschieber ausgebildet ist, der mit einem Endbereich eine Kulisse des Meßbereichsschalters abtastet und mit seinem anderen Ende je nach Schiebestellung einen Eingangsanschluß sperrt oder freigibt.

Der Erfindung liegt die Aufgabe zugrunde, ein Multimeter mit den Merkmalen des Oberbegriffes des Anspruches 1 derart auszubilden, daß die Sperrvorrichtung vereinfacht und insbesondere verkleinert ist und trotzdem eine Mehrzahl von Eingangsanschlüssen durch sie versperrt werden kann.

Diese Aufgabe wird durch die kennzeichnenden Merkmale des Anspruches 1 gelöst, vorteilhafte Weiterbildungen der Erfindung ergeben sich aus den Unteransprüchen 2 - 14.

Als Kern der Erfindung wird es angesehen, die Sperrvorrichtung nach Art eines im wesentlichen in seinem Scheitelpunkt gelagerten, verschwenkbaren Winkelhebels auszubilden, wobei die Endbereiche der streifenartig ausgebildeten Winkelschenkel durch den Meßbereichsschalter in eine mit den zu verschließenden Eingangsanschlüssen fluchtende Stellung gebracht werden kann. Eine derartige Ausführungsform einer Sperrvorrichtung ist einfach und preisgünstig hinsichtlich des Materials herstellbar, sie kann einfach montiert werden und beansprucht innerhalb des Gehäuses nur relativ wenig Platz, da der zwischen den beiden Schenkeln angeordnete Freibereich ausgenutzt werden kann, um einen Eingangsanschluß anzuordnen, der von den beiden Endbereichen der Winkelschenkel nicht verschlossen werden muß, insbesondere einen "Com"-Anschluß des Multimeters.

Gemäß einer Weiterbildung der Erfindung ist an dem Winkelhebel ein mit einem Verstellelement des Meßbereichsschalters in Eingriff bringbarer Schaltvorsprung angeordnet, wobei der Winkelhebel bezogen auf den Schaltvorsprung symmetrisch ausgebildet ist und durch die beiden Schenkel sowie den Schaltvorsprung quasi ein dreigliedriger Stern gebildet wird. Ein derartiges Teil ist ebenfalls leicht herzustellen und leicht zu montieren. Besonders kompakte Verhältnisse innerhalb des Multimetergehäuses bezüglich der Sperrkulissenanordnung ergeben sich dann, wenn die Öffnung des mittleren Eingangsanschlusses, der Lagerpunkt des Winkelhebels und der Drehpunkt des Meßbereichsschalters auf einer Linie liegen. Einen sicheren und stabilen Eingriff zwischen dem Schaltvorsprung und dem Meßbereichsschalter ergibt sich dann, wenn der Schaltvorsprung formschlußartig in zweifacher Hinsicht an den drehbaren Meßbereichsschalter gekoppelt ist, nämlich einerseits durch eine Spitze, die in eine Mitnehmerausnehmung des Meßbereichsschalters eingreift und durch eine Nut, die einen in der Ausnehmung des Meßbereichsschalters angeordneten Mitnehmervorsprung umgreift.

Ganz besonders vorteilhaft ist es, wenn die Sperrvorrichtung in einem wasserdicht gekapselten Gehäuse angeordnet ist. Dann genügt das Multimeter auch relativ, trotz der Anordnung einer Sperrkulissenanordnung, hohen Anforderungen an Wasserdichtigkeit, die im Hinblick auf die Betriebssicherheit des Gerätes von besonderem Vorteil ist. Das Gehäuse der Sperrvorrichtung wird durch eine die Sperrvorrichtung seitlich umgreifende Seitenwandung und eine quasi eine Zwischenwandung bildende Buchsenträgerwandung gebildet, an der einstückig mit den Eingangsanschlüssen fluchtende Kontakthülsen angeordnet sind, in die die Kontakte der Buchsen eingeschweißt sind. Die Durchführung der in den Innenbereich des Multimetergehäuses führenden Leitungen ist dabei wasserdicht ausgeführt. Die Buchsenträgerwandung ist mit der Seitenwandung des Gehäuses verschweißt, durch die Befestigung der Buchsenträgerwandung wird gleichzeitig die Schaltkulisse in ihrer Lagerung schwenkbefestigt.

Die Ansprüche 11 - 13 betreffen Verstärkungselemente im Bereich des Winkelhebels, die eine besonders hohe Belastung der Sperrkulisse erlauben.

Durch die Merkmale des Anspruches 14 wird eine Stabilisierung des wasserdicht gekapselten Gehäuses der Sperrvorrichtung sichergestellt, auch wenn über eingesteckte Kontaktstecker von Meßleitungen relativ hohe mechanische Scherkräfte auf das Multimeter ausgeübt werden.

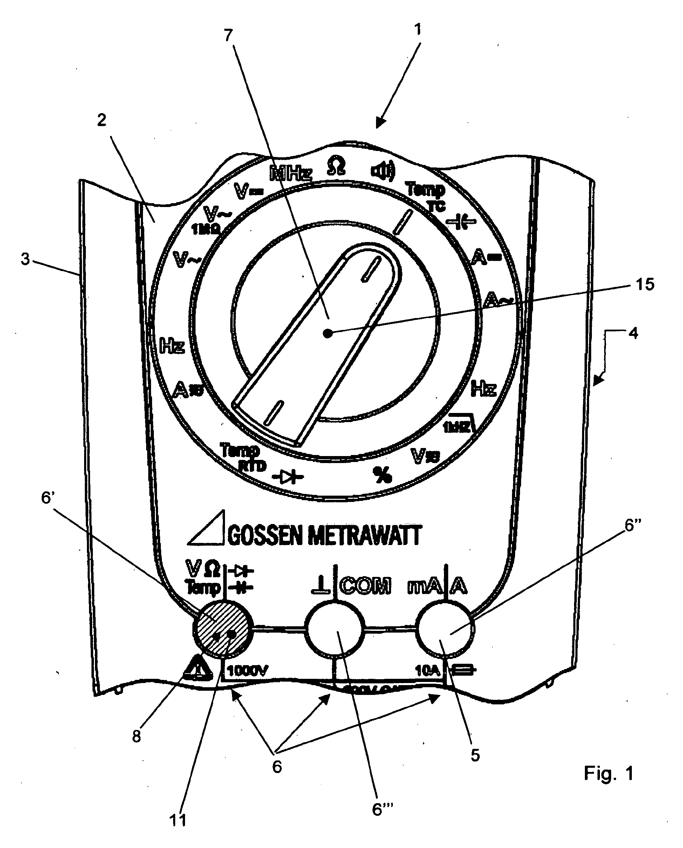

Die Erfindung ist anhand vorteilhafter Ausführungsbeispiele in den Zeichnungsfiguren näher erläutert. Diese zeigen
- Fig. 1: eine Außenansicht des Multimeters mit drei Eingangsanschlüssen, von denen die beiden außenliegenden Eingangsanschlüsse durch die Sperrvorrichtung sperrbar sind;
- Fig. 2: eine Innenansicht der Gehäuseoberschale mit der als verschwenkbarer Winkelhebel ausgebildeten Sperrvorrichtung mit Meßbereichsschalter in einer ersten Schaltstellung;
- Fig. 3: eine Darstellung gemäß Fig. 2 in einer zweiten Schaltstellung;
- Fig. 4: eine Darstellung gemäß Fig. 2 und 3 in einer Zwischenstellung;
- Fig. 5: eine Darstellung gemäß Fig. 2 - 4 in einer dritten Schaltstellung;
- Fig. 6: eine Darstellung gemäß Fig. 2 - 5 in einer vierten Schaltstellung;
- Fig. 7: eine Schnittdarstellung gemäß Schnittlinie A-A gemäß Fig. 4;
- Fig. 8: eine weitere Schnittdarstellung gemäß Schnittlinie B-B in Fig. 5;
- Fig. 9: eine Detailansicht des Formschlußeingriffes gemäß Bereich C in Fig. 4;
- Fig. 10: eine Detaildarstellung des Formschlusses gemäß Bereich D in Fig. 7;

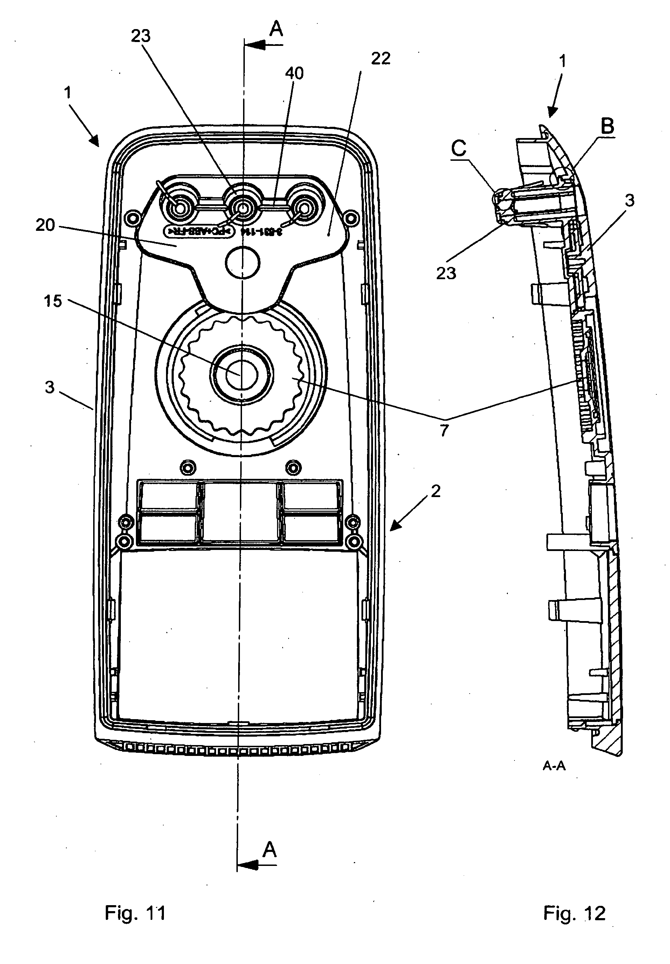

- Fig. 11: eine Innenansicht des Multimeters mit montierter Buchsenträgerwandung;
- Fig. 12: einen Schnitt gemäß Schnittlinie A-A in Fig. 11;
- Fig. 13: eine Darstellung zur Erläuterung der Abdichtung der Buchsenträgerwandung gemäß Detail B in Fig. 12;
- Fig. 14: eine Detailansicht der Buchsenabdichtung gemäß Bereich C in Fig. 12;

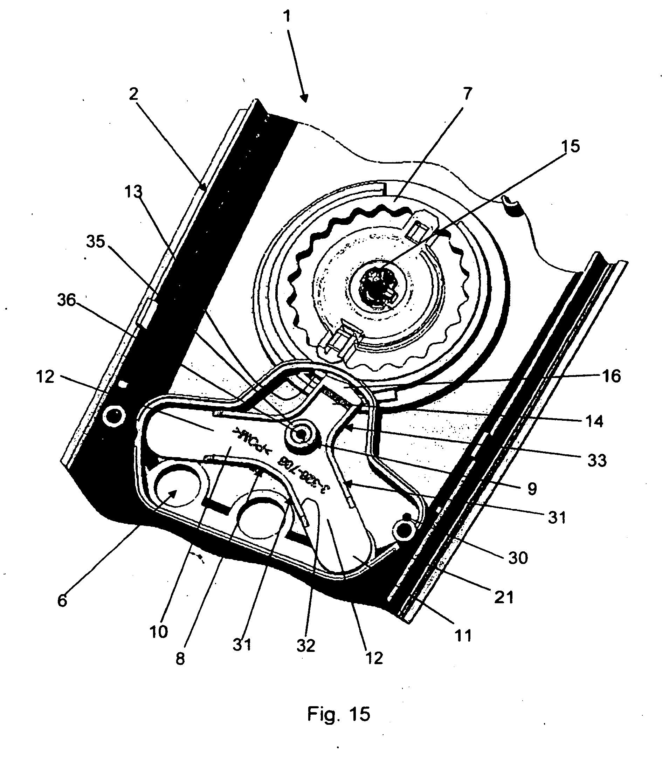

- Fig. 15: eine perspektivische Ansicht der in die Seitenwandungen eingelegten Sperrvorrichtung ohne aufgesetzte Buchsenträgerwandung.

Zunächst wird auf Zeichnungsfigur 1 Bezug genommen. Das Multimeter 1 weist ein Gehäuse 2 auf, das aus zwei Gehäuseschalen 3, 4 zusammengesetzt ist. In der oberen Gehäuseschale 3 sind drei als Steckbuchsen 5 ausgeführte Eingangsanschlüsse 6 vorgesehen, die zum Anschließen von nicht näher dargestellten Meßleitungen dienen. In der Gehäuseoberschale 3 ist ein Meßbereichsschalter 7 vorgesehen, der durch Verdrehen in eine der gewählten Meßgrößen zugeordnete Schaltstellung zu bringen ist. Mit dem Meßbereichsschalter 7 ist eine mechanisch wirkende Sperrvorrichtung 8 gekoppelt, die eine Sperrung der beiden außenliegenden Eingangsanschlüsse 6', 6" in der Weise erlaubt, daß der Stecker einer Meßleitung nur in eine Steckbuchse eingeführt werden kann, die einer mit dem Meßbereichsschalter 7 eingestellten Meßgröße entspricht.

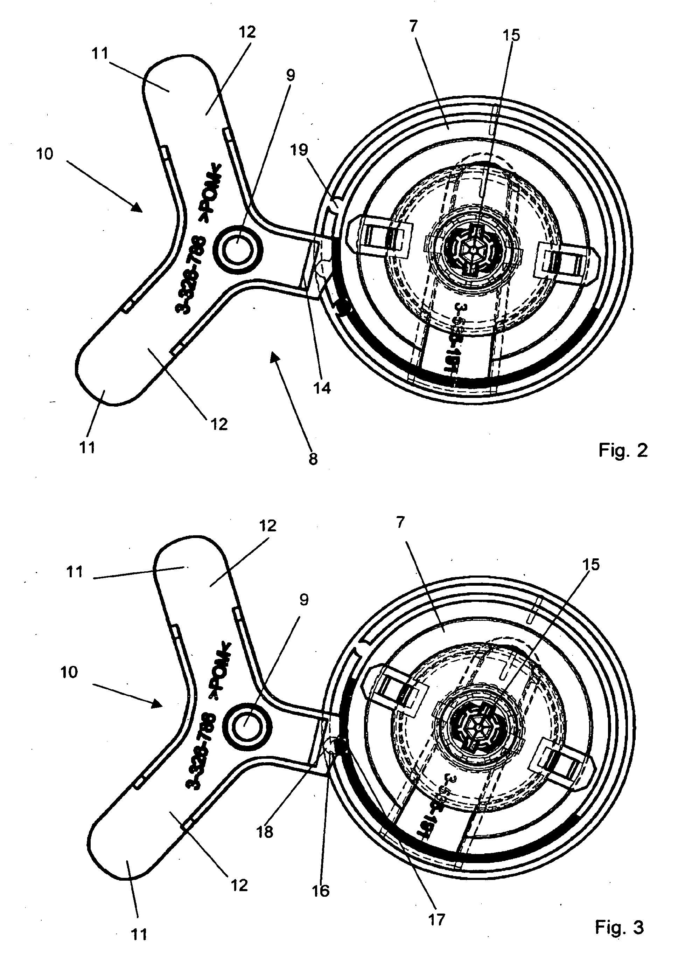

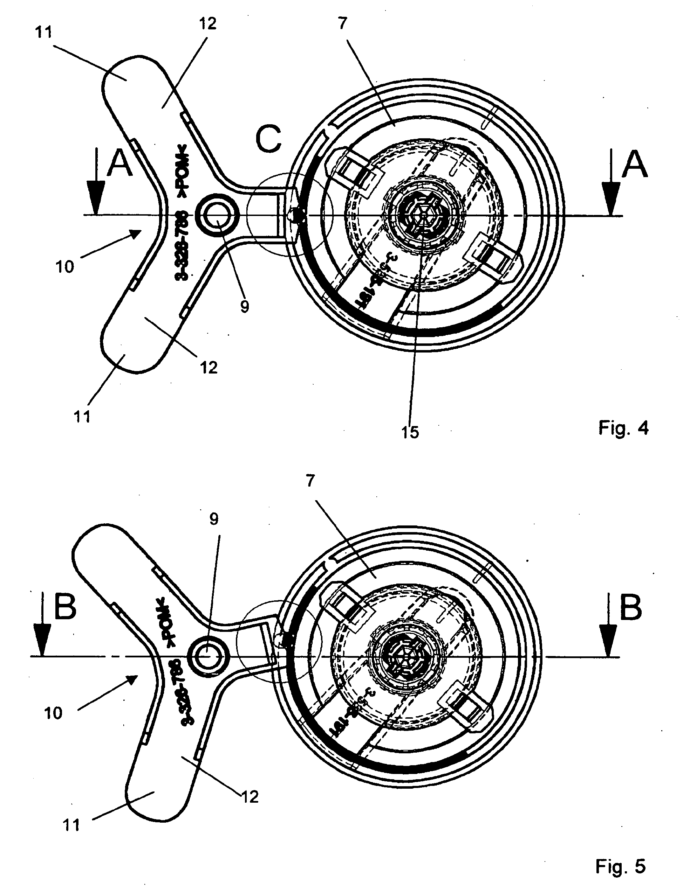

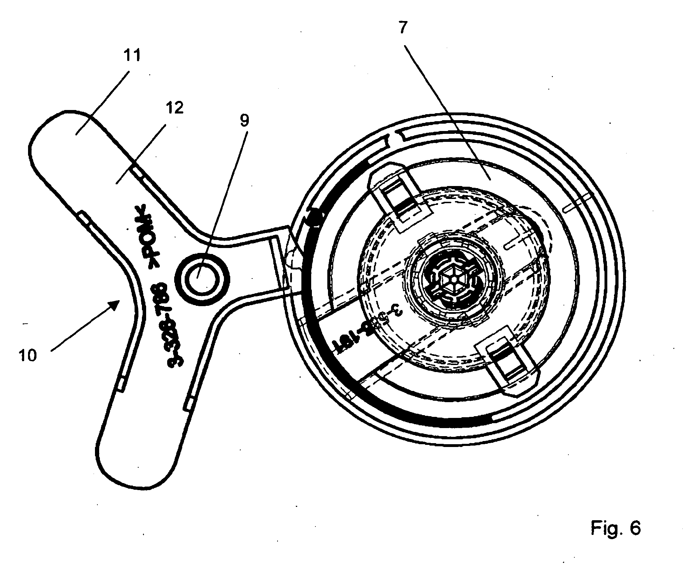

Die Sperrvorrichtung 8 ergibt sich im Detail insbesondere aus den Figuren 2 - 6, wobei die Sperrvorrichtung 8 zusammen mit dem Meßbereichsschalter 7 von der Gehäuseinnenseite her in unterschiedlichen Schaltstellungen dargestellt ist.

Die Sperrvorrichtung 8 ist nach Art eines im wesentlichen in seinem Scheitelpunkt 9 gelagerten verschwenkbaren Winkelhebels 10 ausgebildet, wobei die Endbereiche 11 der streifenartigen Winkelschenkel 12 durch den Meßbereichsschalter 7 in eine mit den zu verschließenden Eingangsanschlüssen 6', 6" fluchtende Stellung gebracht werden können. An dem Winkelhebel 10 ist ein mit dem Verstellelement 13 des Meßbereichsschalters 7 in Eingriff bringbarer Schaltvorsprung 14 angeordnet, wobei der Winkelhebel 10 bezogen auf den Schaltvorsprung 14 symmetrisch ausgebildet ist und durch die beiden Schenkel 12 sowie den Schaltvorsprung 14 ein dreigliedriger Stern gebildet wird. In den Zeichnungsfiguren ist deutlich zu sehen, daß die beiden Winkelschenkel 12 des Winkelhebels 10 den mittleren Eingangsanschluß 6''' übergreifen, so daß dieser nicht durch die Endbereiche 11 der Winkelschenkel 12 verschlossen werden kann.

Die Anordnung des Meßbereichsschalters 7, des Winkelhebels 10 und des mittleren Eingangsanschlusses 6"' ist so getroffen, daß der Lagerpunkt (Scheitelpunkt 9) des Winkelhebels 10, der Drehpunkt 15 des Meßbereichsschalters 7 und die Öffnung des mittleren Eingangsanschlusses 6''' auf einer geraden Linie liegen.

Der Schaltvorsprung 14 weist eine Spitze 16 auf, die in eine Mitnehmerausnehmung des drehbaren Meßbereichsschalters 7 eingreift. Zusätzlich ist im Bereich der Spitze 16 eine Nut 18 angeordnet, die einen in der Ausnehmung 17 des Meßbereichsschalters 7 angeordneten Mitnehmervorsprung 19 umgreift.

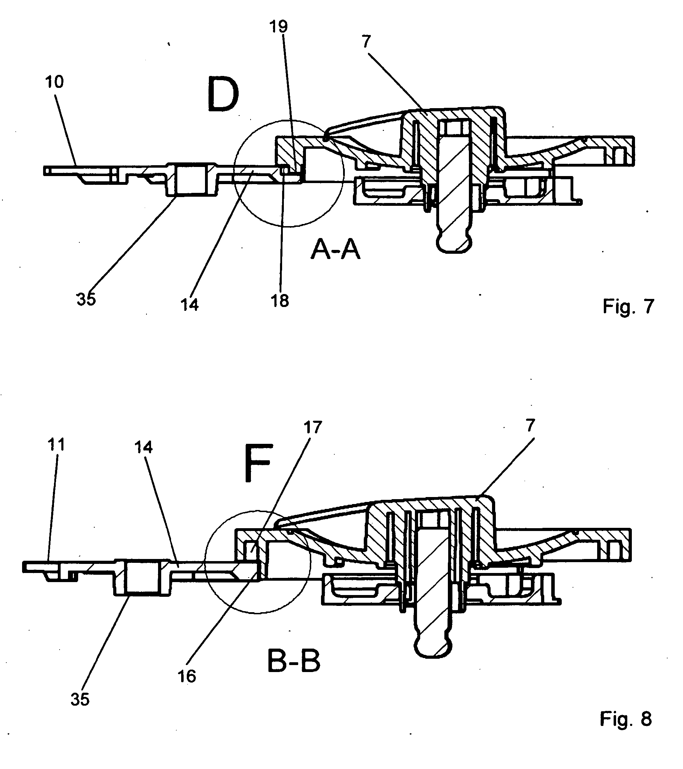

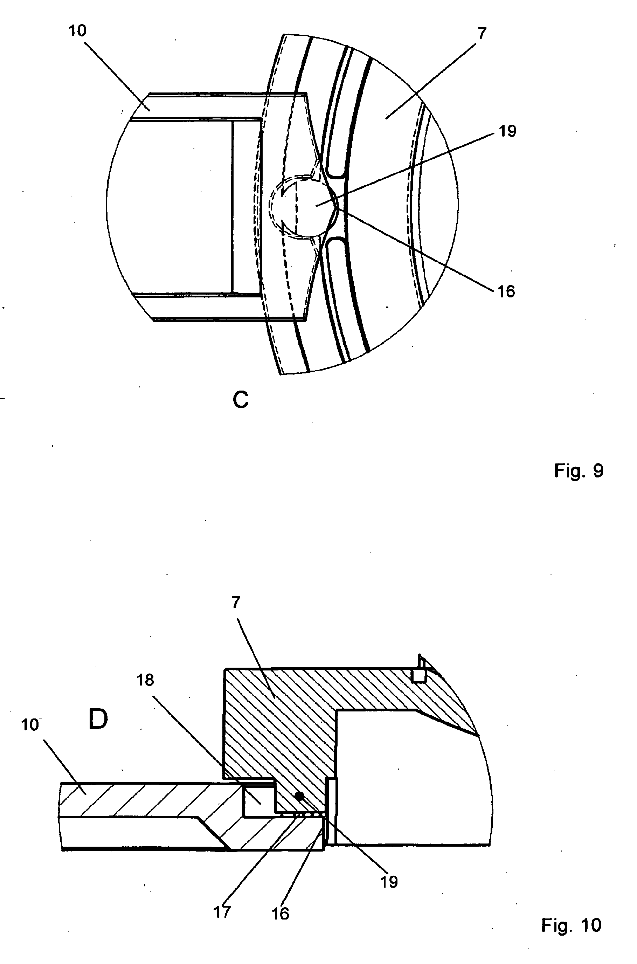

Die den Formschluß bildenden Elemente 16 - 19, die zu einer Verstellung der Sperrvorrichtung 8 in Folge einer Verdrehung des Meßbereichsschalters 7 erforderlich ist, ist im Detail noch einmal in den Figuren 7 - 10 dargestellt.

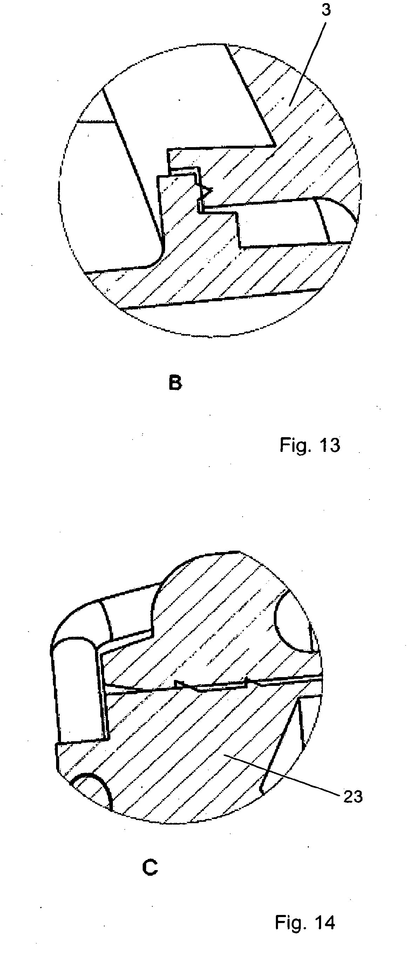

Wie sich insbesondere aus den Zeichnungsfiguren 11 - 15 ergibt, ist die Sperrvorrichtung 8 in einem wasserdicht gekapselten Buchsengehäuse 20 angeordnet, wobei das Buchsengehäuse 20 durch eine die Sperrvorrichtung 8 seitlich umgreifende Seitenwandung und eine Buchsenträgerwandung 22 gebildet ist, an der einstückig mit den Eingangsanschlüssen fluchtende Kontakthülsenträger angeformt sind. Die Kontakte der Buchsen können in die Kontakthülsenträger eingeschweißt sein, es besteht aber auch die Möglichkeit, daß die Kontakte über umlaufende Abdichtungen der Buchsen mit doppeltem Hinterschnitt sowie wie dies in Figur 14 gezeigt ist, abgedichtet sind. In der dargestellten Ausführungsform sind die Kontakte als Kontakthülsen 23 dargestellt, die in hülsenartigen Kontakthülsenträgern angeordnet sind.

Die Buchsenträgerwandung 22 ist mit der Seitenwandung 21 des Gehäuses 20 Ultraschall verschweißt und damit dicht verbunden.

Die Endbereiche 11 der Winkelschenkel 12 sind in Seitenbereiche 30 des Buchsengehäuses 20 verschwenkbar, die oberhalb der mit der Sperrvorrichtung 8 versperrbaren Eingangsanschlüsse 6', 6" liegen. Dies ergibt sich insbesondere aus der Zeichnungsfigur 15.

An den Seitenkanten 31 des Winkelhebels 10 sind Verstärkungsrippen 32 angeordnet, die sich in den Seitenkanten 33 des Schaltvorsprunges 14 fortsetzen.

Der Winkelhebel 10 übergreift mit einem hülsenartigen Lagerelement 35 einen Drehlagervorsprung 36, wobei das Drehlagerelement in einer Ausnehmung der Buchsenträgerwandung 22 gelagert ist.

In Zeichnungsfigur 11 ist noch ersichtlich, daß die in einer Reihe angeordneten Kontakthülsen 23 durch eine zwischen ihnen angeordnete, in die Buchsenträgerwandung 22 übergehende rippenartige Verstärkung 40 miteinander verbunden sind.

## Patentansprüche

1. Multimeter (1) mit einem Gehäuse (2), mit mindestens drei als Steckbuchsen (5) ausgeführten Eingangsanschlüssen (6) zum Anschließen von zwei Meßleitungen, von denen mindestens eine beim Wechsel einer zu untersuchenden Meßgröße mit einem anderen, dieser neuen Meßgröße zugeordneten Eingangsanschluß (6) zu verbinden ist und mit einem Meßbereichsschalter (7), der in eine der gewählten Meßgrößen zugeordnete Schaltstellung zu bringen ist, wobei mit dem Meßbereichsschalter (7) eine mechanisch wirkende Sperrvorrichtung (8) gekoppelt ist, die eine Sperrung bestimmter Eingangsanschlüsse (6', 6") in der Weise erlaubt, daß eine über die Meßleitungen ein Meßsignal aufnehmende Kontaktierung nur jeweils der Eingangsanschlüsse erfolgen kann, denen eine Meßgröße zugeordnet ist, die der mit dem Meßbereichsschalter (7) eingestellten Meßgröße entspricht, wobei die Sperrvorrichtung (8) nach Art eines im wesentlichen in seinem Scheitelpunkt (9) gelagerten verschwenkbaren Winkelhebels (10) mit streifenartigen Winkelschenkeln (12) ausgebildet ist, wobei die Endbereiche (11) der streifenartigen Winkelschenkel (12) durch den Meßbereichsschalter (7) in eine mit den zu verschließenden Eingangsanschlüssen (6', 6") abdeckende Stellung bringbar sind,
**dadurch gekennzeichnet, daß**
die Sperrvorrichtung (8) in einem Buchsengehäuse (20) angeordnet ist, das durch eine die Sperrvorrichtung (8) seitlich umgreifende Seitenwandung (21) und eine Buchsenträgerwandung (22) gebildet ist und wobei die Buchsenträgerwandung (22) mit der Seitenwandung (21) des Gehäuses (2) dicht verbunden ist.

2. Multimeter nach Anspruch 1,
**dadurch gekennzeichnet, daß**
an dem Winkelhebel (10) ein mit einem Verstellelement (13) des Meßbereichsschalters (7) in Eingriff bringbarer Schaltvorsprung (14) angeordnet ist.

3. Multimeter nach Anspruch 2,
**dadurch gekennzeichnet, daß**
der Winkelhebel (10) bezogen auf den Schaltvorsprung (14) symmetrisch ausgebildet ist und durch die beiden Winkelschenkel (12) sowie den Schaltvorsprung (14) ein 3-gliedriger Stern gebildet wird.

4. Multimeter nach einem der Ansprüche 1 - 3,
**dadurch gekennzeichnet, daß**
die beiden Winkelschenkel (12) des Winkelhebels (10) einen mittleren Eingangsanschluß (6"') übergreifen.

5. Multimeter nach Anspruch 4,
**dadurch gekennzeichnet, daß**
die Öffnung des mittleren Eingangsanschlusses (6'''), der Lagerpunkt des Winkelhebels (10) und der Drehpunkt (15) des Meßbereichsschalters (7) auf einer geraden Linie liegen.

6. Multimeter nach einem der Ansprüche 2 - 5,
**dadurch gekennzeichnet, daß**
der Schaltvorsprung (14) eine Spitze (16) hat, die in eine MitnehmerAusnehmung (17) des drehbaren Meßbereichsschalters (7) eingreift.

7. Multimeter nach Anspruch 6,
**dadurch gekennzeichnet, daß**
im Bereich der Spitze (16) eine Nut (18) angeordnet ist, die einen in der Ausnehmung (17) des Meßbereichsschalters (7) angeordneten Mitnehmervorsprung (14) umgreift.

8. Multimeter nach einem der vorhergehenden Ansprüche,
**dadurch gekennzeichnet, daß**
- an der Buchsenträgerwandung (22) einstückig Kontakthülsenträger angeformt sind,
- der Kontakthülsenträger mit den Eingangsanschlüssen (6) fluchtet,
- in den Kontakthülsenträgern Kontakte der Eingangsanschlüsse (6) eingeschweißt sind.

9. Multimeter nach einem der vorhergehenden Ansprüche,
**dadurch gekennzeichnet, daß**
die Buchsenträgerwandung (22) mit der Seitenwandung (21) des Gehäuses (20) verschweißt ist.

10. Multimeter nach einem der vorhergehenden Ansprüche,
**dadurch gekennzeichnet, daß**
die Endbereiche (11) der Winkelschenkel (12) in Seitenbereiche (30) des Buchsengehäuses (20) verschwenkbar sind, die oberhalb der mit der Sperrvorrichtung (8) versperrbaren Eingangsanschlüsse (6', 6") angeordnet sind.

11. Multimeter nach einem der vorhergehenden Ansprüche,
**dadurch gekennzeichnet, daß**
an den Seitenkanten (31) des Winkelhebels (10) Verstärkungsrippen (32) angeordnet sind.

12. Multimeter nach einem der Ansprüche 2 und 11,
**dadurch gekennzeichnet, daß**
sich die Verstärkungsrippen (32) der Seitenkanten (31) des Winkelhebels (10) in den Seitenkanten (33) des Schaltvorsprunges (14) fortsetzen.

13. Multimeter nach einem der vorhergehenden Ansprüche,
**dadurch gekennzeichnet, daß**
der Winkelhebel (10) mit einem hülsenartigen Lagerelement (35) einen Drehlagervorsprung (36) umgreift und das Drehlagerelement in einer Ausnehmung der Buchsenträgerwandung (22) gelagert ist.

14. Multimeter nach einem der Ansprüche 8 - 13,
**dadurch gekennzeichnet, daß**
die in einer Reihe angeordneten Kontakthülsen (23) durch eine zwischen ihnen angeordnete, in die Buchsenträgerwandung (22) übergehende Verstärkung (40) miteinander verbunden sind.

## Claims

1. A multimeter (1) comprising a housing (2) having at least three input connections (6), being female connectors (5) for connecting to two measurement lines, and when a new measurement variable is to be measured, it is possible to connect at least one of the measurement lines to another one of said input connections (6) being associated with the new measurement variable, a measurement-range switch (7) being moved to a switching position associated with selected measurement variables, wherein a mechanical blocking apparatus (8) is coupled to said measurement-range switch (7), said blocking apparatus allowing specific ones of said input connections (6', 6") to be blocked such that contact, which carries a measurement signal via the measurement lines, can be made only with said input connections having an associated measurement variable set by said measurement-range switch (7), said blocking apparatus (8) having an apex (9) and a pivotable angle lever (10) mounted substantially at said apex, said angle lever having strip-shaped angle limbs (12) with end regions (11) and said measurement-range switch (7) can move said end regions (11) of said strip-shaped angle limbs (12) to a position covering a respective one of said input connections (6', 6") to be blocked,
**characterized in that**
the blocking apparatus (8) is disposed in a connector housing (20), said connector housing having side walls (21) laterally surrounding said blocking apparatus and a connector-support wall (22) and wherein said connector-support wall (22) is tightly connected with the side wall (21) of the housing (2).

2. The multimeter according to claim 1,
**characterized in that**
a switching projection (14) is disposed on the angle lever (10) for engaging said switching projection (14) with an adjustment element (13) disposed on the measurement-range switch (7).

3. The multimeter according to claim 2,
**characterized in that**
the angle lever (10) is formed symmetrically in relation to the switching projection (14), and a three-pointed star is formed by the two angle limbs (12) as well as the switching projection (14).

4. The multimeter according to one of the claims 1 to 3,
**characterized in that**
the two angle limbs (12) of the angle lever (10) extend beside a central input connection (6"').

5. The multimeter according to claim 4,
**characterized in that**
the opening of the central input connection (6"'), the bearing point of the angle lever (10) and the center of rotation (15) of the measurement-range switch (7) lie on a straight line.

6. The multimeter according to one of the claims 2 to 5,
**characterized in that**
the switching projection (14) has a nib (16) engaging in a driver recess (17) of the pivotable measurement-range switch (7).

7. The multimeter according to claim 6,
**characterized in that**
the measurement-range switch (7) has a driver projection (14) extending in the driver recess (17) and the nib (16) has a groove (18) formed therein and encompassing said driver projection (14).

8. The multimeter according to one of the preceding claims,
**characterized in that**
- contact bushings are integrally disposed in the connector-support wall (22),
- the contact bushing is aligned with the input connections (6),
- contacts of the input connections (6) are welded to said contact bushings.

9. The multimeter according to one of the preceding claims,
**characterized in that**
the connector-support wall (22) is welded to the side walls (21) of the connector housing (20).

10. The multimeter according to one of the preceding claims,
**characterized in that**
the end regions (11) of the angle limbs (12) can be pivoted into the side regions (30) of the connector housing (20), said side regions are disposed above the input connections (6', 6") which can be blocked by the blocking apparatus (8).

11. The multimeter according to one of the preceding claims,
**characterized in that**
the angle lever (10) has side edges (31) and reinforcing ribs (32) disposed on the side edges.

12. The multimeter according to claims 2 and 11,
**characterized in that**
the reinforcing ribs (32) of the side edges (31) of the angle lever (10) continue in side edges (33) of the switching projection (14).

13. The multimeter according to one of the preceding claims,
**characterized in that**
the angle lever (10) encompasses a pivot-bearing projection (36) with a bushing-like bearing element (35) and the pivot-bearing element being mounted in a recess in the connector-support wall (22).

14. The multimeter according to one of the claims 8 to 13,
**characterized in that**
the contact bushings (23) are disposed in series and connected to one another by a reinforcement device (40), said reinforcement device disposed between said contact bushings and merges with said connector-support wall (22).

## Revendications

1. Multimètre (1) pourvu d'un boîtier (2) comprenant au moins trois raccords d'entrée (6) qui sont réalisés sous la forme de fiches femelles (5), qui sont destinés au raccordement de deux conducteurs de mesure dont un au moins, lors du changement de la grandeur à mesurer qu'il s'agit de contrôler, doit être relié à un autre raccord d'entrée (6) associé à cette nouvelle grandeur à mesurer, et comprenant un sélecteur de gammes (7) qui doit être amené dans une position de commutation associée à la grandeur à mesurer choisie, sachant qu'est accouplé au sélecteur de gammes (7) un dispositif de blocage (8) à action mécanique qui permet un blocage de raccords d'entrée déterminés (6', 6") d'une manière telle qu'une mise en contact de réception d'un signal de mesure par l'intermédiaire des conducteurs de mesure ne peut avoir lieu à chaque fois que sur les raccords d'entrée auxquels est associée une grandeur à mesurer correspondant à la grandeur à mesurer qui a été réglée au moyen du sélecteur de gammes (7), sachant que le dispositif de blocage (8) est pourvu d'un apex (9) et d'un levier angulaire (10) rotatif assemblé sensiblement à l'apex, le levier angulaire comportant des ailes d'angle (12) en forme de bande comprenant des extrémités (11) et lesdites extrémités desdites ailes d'angle (12) en forme de bande peuvent être amenées par ledit sélecteur de gammes (7) dans une position qui couvre les raccords d'entrée (6', 6") à bloquer,
**caractérisé en ce que**
ledit dispositif de blocage (8) est disposé dans un boîtier de connexion (20), le boîtier de connexion ayant des parois latérales (21) qui entourent latéralement ledit dispositif de blocage (8) et une paroi de support de douilles (22), sachant que la paroi de support de douilles (22) est connectée étroitement à la paroi latérale (21) dudit boîtier (2).

2. Multimètre selon la revendication 1,
**caractérisé en ce que**
une saillie (14) est disposée sur ledit levier angulaire (10) pour s'engager avec un élément d'ajustement (13) disposé sur ledit sélecteur de gammes (7).

3. Multimètre selon la revendication 2,
**caractérisé en ce que**
ledit levier angulaire (10) a une forme symétrique relatif à ladite saillie (14) et une étoile à trois pointes est formée par les deux ailes d'angle (12) ainsi que ladite saillie (14).

4. Multimètre selon l'une des revendications 1 à 3,
**caractérisé en ce que**
les deux ailes d'angle (12) du levier angulaire (10) s'étendent à côté d'un raccord d'entrée central (6"').

5. Multimètre selon la revendication 4,
**caractérisé en ce que**
l'ouverture dudit raccord d'entrée central (6"'), le point d'appui du levier angulaire (10) et le centre de rotation (15) dudit sélecteur de gammes (7) sont situés sur une droite.

6. Multimètre selon l'une des revendications 2 à 5,
**caractérisé en ce que**
ladite saillie (14) comporte une pointe (16) qui s'engage avec un creux d'entraînement (17) dudit sélecteur de gammes rotatif (7).

7. Multimètre selon la revendication 6,
**caractérisé en ce que**
ledit sélecteur de gammes (7) comporte une saillie d'entraînement (14) qui s'étend dans ledit creux d'entraînement (17) et une rainure (18) est disposée dans la région de la pointe (16), la rainure entourant ladite saillie d'entraînement (14).

8. Multimètre selon l'une des revendications précédentes,
**caractérisé en ce que**
- des douilles de contact sont intégralement disposées dans ladite paroi de support de douilles (22),
- la douille de contact est alignée avec lesdits raccords d'entrée (6),
- des contacts des raccords d'entrée (6) sont soudés avec les douilles de contact.

9. Multimètre selon l'une des revendications précédentes,
**caractérisé en ce que**
ladite paroi de support de douilles (22) est soudée avec la paroi latérale (21) dudit boîtier (20).

10. Multimètre selon l'une des revendications précédentes,
**caractérisé en ce que**
lesdites extrémités (11) des ailes d'angle (12) peuvent être pivotées sur les côtés latéraux (30) du boîtier de connexion (20), les côtés latéraux étant disposés au-dessus desdits raccords d'entrée (6', 6") qui peuvent être bloqués par ledit dispositif de blocage (8).

11. Multimètre selon l'une des revendications précédentes,
**caractérisé en ce que**
des nervures de renforcement (32) sont disposées aux bords latéraux (31) dudit levier angulaire (10).

12. Multimètre selon l'une des revendications 2 à 11,
**caractérisé en ce que**
lesdites nervures de renforcement (32) des bords latéraux (31) dudit levier angulaire (10) se prolongent le long de bords latéraux (33) de ladite saillie (14).

13. Multimètre selon l'une des revendications précédentes,
**caractérisé en ce que**
ledit levier angulaire (10) entoure une saillie de palier rotatif (36) avec un élément de palier de type douille (35) et l'élément de palier rotatif étant monté dans un creux de la paroi de support de douilles (22).

14. Multimètre selon l'une des revendications 8 à 13,
**caractérisé en ce que**
lesdites douilles de contact (23) sont agencées en série et connectées l'une à l'autre par un dispositif de renforcement (40), ledit dispositif de renforcement étant disposé entre les douilles de contact et aligné avec ladite paroi de support de douilles (22).
